# EUROPEAN PATENT SPECIFICATION

(11) **EP 1 920 843 B1**
(45) Date of publication and mention of the grant of the patent: **02.08.2017**
(21) Application number: 07120066.1
(22) Date of filing: 06.11.2007
(51) Int. Cl.: B01L 3/00

(54) **Valve unit, microfluidic device with the valve unit, and microfluidic substrate**
Ventileinheit, Mikrofluidvorrichtung mit der Ventileinheit und mikrofluidisches Substrat
Unité de soupape, dispositif microfluide avec l'unité de soupape, et substrat microfluide

(30) Priority: 09.11.2006 KR 20060110543
(43) Date of publication of application: 14.05.2008
(73) Proprietor: Samsung Electronics Co., Ltd., Suwon-si, Gyeonggi-do, 443-742 (KR)
(72) Inventor: Lee, Beom-seok c/o Samsung Advanced Institute of Technology, Gyeonggi-do (KR); Cho, Yoon-kyoung c/o Samsung Advanced Institute of Technology, Gyeonggi-do (KR); Lee, Jeong-gun c/o Samsung Advanced Institute of Technology, Gyeonggi-do (KR); Park, Jong-myeon c/o Samsung Advanced Institute of Technology, Gyeonggi-do (KR)
(74) Representative: Grünecker Patent- und Rechtsanwälte PartG mbB

(56) References cited:
- WO-A-2005/107947
- WO-A-2006/104467
- US-A1- 2004 007 275
- US-A1- 2004 219 732
- US-A1- 2005 247 356
- US-A1- 2006 219 308

## Description

### BACKGROUND OF THE INVENTION

### 1. Field of the Invention

The present invention relates to a valve unit for timely closing and opening a microfluidic channel, a microfluidic device including the valve unit, and a microfluidic substrate..

### 2. Description of the Related Art

Microfluidic channels are generally formed in a substrate (e.g., a lab-on-a-chip) used for performing, for example, biochemical reactions such as a lysis reaction and a polymerase chain reaction (PCR). A valve unit may be used to timely close and open such a microfluidic channel to regulate a fluid flow.

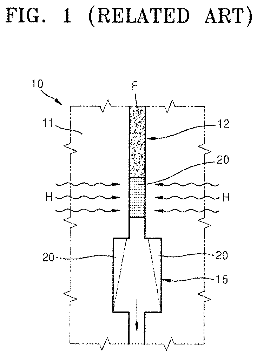

FIG. 1 is a plan view illustrating a conventional valve unit 10 disclosed in Robin Hui Liu et al., Anal. Chem. Vol. 76, pp. 1824-1831, 2004.

Referring to FIG. 1, the valve unit 10 includes a micro channel 12 forming a fluid passage, paraffin wax 20 preventing a flow of fluid (F) by closing the micro channel 12, and a wax chamber 15 adjacent to the paraffin wax 20. When it is necessary to move the fluid (F), heat (H) is applied to the paraffin wax 20 to melt the paraffin wax 20. As a result, the micro channel 12 is opened, and the fluid (F) can flow downward in the direction of the phantom arrow. Since the melted paraffin wax 20 is collected in the wax chamber 15, which is a widened area of the micro channel 12, the flow of the fluid (F) is not obstructed by the paraffin wax 20.

The valve unit 10 is called an open valve unit. That is, the valve unit 10 opens the initially-closed micro channel 12. In contrast, a close valve unit blocks an initially-opened micro channel. These known open valve unit and the close valve unit can either open or close microchannels, but are not be able to function to open and close a micro channel. In addition, a valve unit that can repeatedly open and close a micro channel has not been proposed yet. However, a substrate suitable for complex fluid reactions becomes quite bulky since several microfluidic chambers, channels, and open valve units and close valve units should be included in the substrate. Furthermore, the process of manufacturing the substrate is expensive and time-consuming.

US-A-2004/007275 discloses a fluidic valve and an integrated bio-micro-fluidic device. A valve is disclosed which is a so-called open-close-open fluidic valve. This has an initial open state which may be switched to a close state and back to an open state. A particular channel connecting an inlet port and an outlet port is used as some kind of fluid passage. A bi-phase valve element is arranged in a valve element source chamber. A first heating zone may be used for melting the valve element, which then is pressed to the channel and will again re-solidify, closing the fluid communication channel. For pressing the valve element to the corresponding position, a valve element pump is used. This pump is fluidically coupled to the valve element source chamber at pump port.

WO 2005/017947 A discloses a valve for controlling fluid flow in a micro-fluidic device. Corresponding valve comprises a chamber, a heating coil, and a valve material contained in the chamber. When the valve appears to be closed, the heating coil is activated causing the valve material to expand out of the chamber, through a neck portion and into the main channel. Thereby, the valve channel is blocked. After melting the valve material, this will flow into the main channel, where upon it cools and solidifies.

### SUMMARY OF THE INVENTION

It is an object of the present invention to provide a valve unit, a micro-fluidic device including a valve unit, and a micro-fluidic substrate which has a simple structure and which is easy to design such that they are simultaneously reusable. This object is solved by the features of the independent claims.

Advantageous embodiments are disclosed by the sub-claims.

According to an aspect of the present disclosure, there is disclosed a valve unit and a microfluidic device including the valve unit.The valve unit includes: a first and a second drain chambers formed along the channel, the drain chambers are spaced from each other; a valve substance including a phase change material that is non-fluidic at ambient temperature and fluidic when energy is applied thereto; a valve substance container which contains the valve substance; and a valve connection path which connects the valve substance container to the channel, in which a connection point of the channel where the valve connection path meets the channel is located between the first drain chamber and the second drain chamber, wherein when energy is applied to the valve substance contained in the valve substance container, the valve substance becomes fluidic and at least portion of the valve substance flows to the channel through the valve connection path, and the portion of the valve substance flowed in the channel becomes non-fluidic and blocks the channel; and when energy is applied to the portion of the valve substance blocking the channel, the portion of the valve substance becomes fluidic and discharged to the drain chambers to open the channel.

According to another aspect of the present disclosure, there is disclosed a microfluidic substrate including: a channel which forms a fluid passage; a first and a second drain chambers formed along the channel, the drain chambers are spaced from each other; a valve substance including a phase change material that is non-fluidic at ambient temperature and fluidic when energy is applied thereto; a valve substance container which contains the valve substance; and a valve connection path which connects the valve substance container to the channel, in which a connection point of the channel where the valve connection path meets the channel is located between the first drain chamber and the second drain chamber, wherein when energy is applied to the valve substance contained in the valve substance container, the valve substance becomes fluidic and at least portion of the valve substance flows to the channel through the valve connection path, and the portion of the valve substance flowed in the channel becomes non-fluidic and blocks the channel; and when energy is applied to the portion of the valve substance blocking the channel, the portion of the valve substance becomes fluidic and discharged to the drain chambers to open the channel.

According to another aspect of the present disclosure, there is disclosed a valve unit which includes: a channel which forms a fluid flow path; a valve substance including a phase change material that is non-fluidic at ambient temperature and fluidic when energy is applied thereto; a valve substance container which contains the valve substance; a first area of a first dimension ("D1"), which is formed in the channel; a pair of second areas of a second dimension ("D2"), which are formed in the channel and spaced from each other with a gap ("G"); and a valve connection path which fluid connects the valve substance container to the first area, wherein the gap between the pair of the second areas corresponds to the first area, wherein D1 > D2; wherein D2 is smaller than the dimension of the channel; wherein when energy is applied to the valve substance contained in the valve substance container, the valve substance becomes fluidic and at least portion of the valve substance flows to the channel through the valve connection path, and the portion of the valve substance flowed into the channel becomes non-fluidic and blocks the channel at the second areas; and when energy is applied to the portion of the valve substance blocking the channel, the portion of the valve substance becomes fluidic, resulting in opening the channel.

According to still another aspect of the present disclosure, there is disclosed a microfluidic device including a substrate composed of a first plate and a second plate, which are coupled to each other to provide a channel which forms a fluid flow path; a chamber to receive a fluid from the channel; and a valve unit to control the flow of the fluid in the channel, wherein the valve unit includes a valve substance including a phase change material that is non-fluidic at ambient temperature and fluidic when energy is applied thereto; a valve substance container which contains the valve substance; a first area of a first dimension ("D1"), which is formed in the channel; a pair of second areas of a second dimension ("D2"), which are formed in the channel and spaced from each other with a gap ("G"); and a valve connection path which fluid connects the valve substance container to the first area, wherein the gap between the pair of the second areas corresponds to the first area, wherein D 1 > D2; wherein D2 is smaller than the dimension of the channel; wherein when energy is applied to the valve substance contained in the valve substance container, the valve substance becomes fluidic and at least portion of the valve substance flows to the channel through the valve connection path, and the portion of the valve substance flowed into the channel becomes non-fluidic and blocks the channel at the second areas; and when energy is applied to the portion of the valve substance blocking the channel, the portion of the valve substance becomes fluidic, resulting in opening the channel.

There may be provided an external energy source which radiates electromagnetic waves to the valve substance.

The energy source may include a laser light source emitting laser light.

The laser light source may include a laser diode.

The laser light emitted from the laser light source may be pulsed electromagnetic waves having an energy rate of at least 1 mJ/pulse.

The laser light emitted from the laser light source may be continuous electromagnetic waves having a power of at least 10 mW.

The laser light emitted from the laser light source may have a wavelength in a range of 750 nm to 1300 nm.

The energy source may emit infrared light or inject a high-temperature gas. The gas may have a temperature at which the phase change material can be melted to fluidic state, for example about 65-80 °C.

The valve substance may further include a number of fine thermal particles dispersed into the phase change material and capable of emitting heat by absorbing energy.

The fine thermal particles may have a diameter in a range of 1 nm to 100 µm.

The fine thermal particles may be dispersed into hydrophobic carrier oil.

The fine thermal particles may include a ferromagnetic material or a metal oxide.

The metal oxide may include at least one selected from the group consisting of Al₂O₃, TiO₂, Ta₂O₃, Fe₂O₃, Fe₃O₄ and HfO₂.

The fine thermal particles may be polymer particles, quantum dots, or magnetic beads.

The magnetic beads may include at least one component selected from the group consisting of Fe, Ni, Cr, and an oxide thereof.

The phase change material may be at least one material selected from the group consisting of wax, a gel, and a thermoplastic resin.

The wax may be at least one selected from the group consisting of paraffin wax, microcrystalline wax, synthetic wax, and natural wax.

The gel material may be at least one material selected from the group consisting of polyacrylamide, polyacrylate, polymethacrylate, and polyvinylamide.

The thermoplastic resin may be at least one resin selected from the group consisting of cyclic olefin copolymer (COC), polymethylmethacrylate (acrylic) (PMMA), polycarbonate (PC), polystyrene (PS), polyacetal engineering polymers (POM), perfluoroalkoxy (PFA), polyvinyl chloride (PVC), polypropylene (PP), polyethylene terephthalate (PET), polyetheretherketone (PEEK), polyamide (PA), polysulfone (PSU), polyvinylidene difluoride (PVDF), or the like may be employed as the thermoplastic resin..

In one exemplary embodiment, the valve substance container may be connected to a plurality of separate channels each through a valve connection path, each of the channels forming the fluid passage and provided with the first drain chamber and the second drain chamber.

The valve unit may further include: a fluid chamber which contains a fluid; and a fluid connection path which connects the fluid chamber to the valve substance container at the connection point of the channel, wherein when energy is applied to the valve substance contained in the valve substance container, the valve substance becomes fluidic and at least portion of the valve substance flows to the channel and to the fluid connection path through the valve connection path, and the portion of the valve substance flowed in the channel and the fluid connection path becomes non-fluidic and blocks the channel and the fluid connection path; and when energy is applied to the portion of the valve substance blocking the channel and the fluid connection path, the portion of the valve substance becomes fluidic and discharged to the drain chambers to open the channel and the fluid connection path.

In the microfluidic device, the valve substance container, the valve connection path, and the drain chambers may be formed in a substrate together with the channel, and the energy source may be disposed outside the substrate.

At least a portion of the substrate may be transparent so as to allow the electromagnetic waves to propagate through the substrate.

The microfluidic device may further include an actuating unit which rotates the substrate, wherein the fluid is pumped by a centrifugal force generated when the actuator rotates the substrate.

### BRIEF DESCRIPTION OF THE DRAWINGS

The above and other features and advantages of the present invention will become more apparent by describing in detail exemplary embodiments thereof with reference to the attached drawings in which:
FIG. 1 is a plan view illustrating a conventional valve unit;
FIGS. 2A through 2F are perspective views for explaining an operation of a valve unit according to an embodiment of the present invention;
FIG. 3 is a perspective view illustrating a valve unit according to another embodiment of the present invention;
FIG. 4 is a temperature-time graph for the case when a laser light is projected onto pure paraffin wax and paraffin wax containing fine thermal particles that emit heat so as to compare melting point versus time properties of the pure paraffin wax and the paraffin wax containing the fine thermal particles according to an embodiment of the present invention;
FIG. 5 is a perspective view illustrating a fluid treating apparatus including the valve unit depicted in FIGS. 2A through 2F, according to an embodiment of the present invention;
FIGS. 6A through 6C are photographic images illustrating operation test results of the fluid treating apparatus depicted in FIG. 5, according to an embodiment of the present invention, each accompany with respective illustrative drawings;
FIGS. 7A through 7E are plan views for explaining an operation of a valve unit according to another embodiment of the present invention;
FIGS. 8A through 8E are plan views for explaining an operation of a valve unit according to another embodiment of the present invention;
FIG. 9 is a sectional view taken along line IX-IX of FIG. 8A for explaining an operation of the valve unit according to an embodiment of the present invention; and
FIG. 10 is a sectional view of a valve unit according to another embodiment of the present invention.

### DETAILED DESCRIPTION OF THE INVENTION

A valve unit and a microfluidic device including the valve unit will now be described more fully with reference to the accompanying drawings, in which exemplary embodiments of the invention are shown.

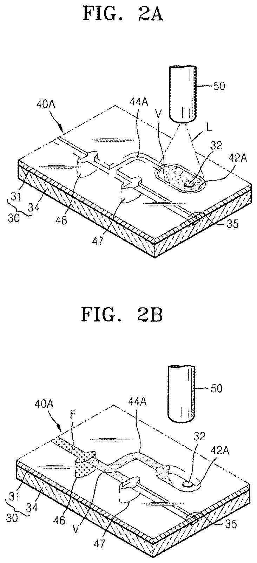

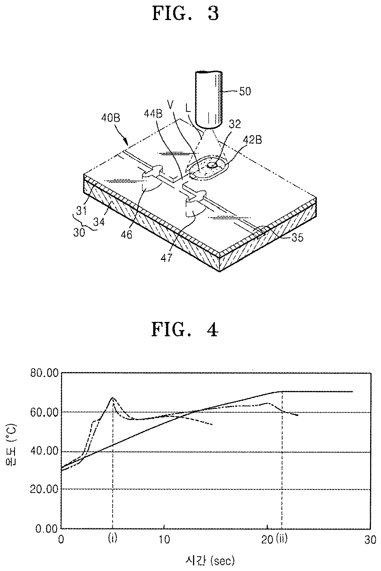

FIGS. 2A through 2F are perspective views for explaining an operation of a valve unit 40A according to an embodiment of the present invention, and FIG. 3 is a perspective view illustrating a valve unit according to another embodiment of the present invention.

Referring to FIGS. 2A through 2F, the valve unit 40A according to an embodiment of the present invention includes a valve substance container 42A, a valve substance (V) contained in the valve substance container 42A, a valve connection path 44A connecting the valve substance container 42A to a channel 35, which forms a passage for fluid (F), and a pair of drain chambers 46 and 47 formed along the channel 35 at both sides of the valve connection path 44A. It should be understood that the chambers and containers are fluid connected to the channel and have a greater depth than the channels. The valve unit 40A further includes an energy source such as a laser light source 50 to supply energy to the valve substance V. The laser light source 50 emits a laser light (L) (electromagnetic waves). However, the energy source of the present invention is not limited to the laser light source 50. That is, other devices such as an infrared source or a high-temperature gas injector can be used as the energy source.

The valve substance container 42A, the channel 35, the valve connection path 44A, and the drain chambers 46 and 47 can be formed in a substrate 30 formed of a upper and a lower plates 31 and 34, which are bonded together. For example, the first and second plates 31 and 34 can be bonded by a known method, such as using an adhesive agent, a double-sided tape, or ultrasonic welding.

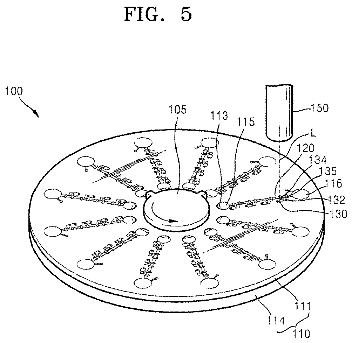

One exemplary embodiment of the substrate 30 is shown in FIG. 5. For example, the valve substance container 42A, the channel 35, the valve connection path 44A, and the drain chambers 46 and 47 may be formed in the lower plate 34, and a valve substance injection hole 32 is formed through the upper plate 31 to fill the valve substance container 42A with the valve substance V. The channel 35 and the valve connection path 44A have micro dimensions (about 1 mm wide and about 0.1 mm deep). In one embodiment, the drain chambers 46 and 47 are about 3 mm deep, and the valve substance container 42A is not deeper than the drain chambers 46 and 47. For example, the valve substance container 42A is about 1 mm deep.

At least a portion or all portion of the upper plate 31 of the substrate 30 is transparent, such that laser light (L) emitted from the laser light source 50 located above the substrate 30 can be irradiated to the valve substance (V) through the upper plate 31. The laser light source 50 is provided in a way to allow its free movement in a precisely controlled manner above the substrate so that it can irradiate laser light to an exact target point of the substrate. The upper plate 31 may be formed of glass or a transparent plastic. The lower plate 34 can be formed of the same material as the upper plate 31. Alternatively, the lower plate 34 can be formed of a silicon material having a high thermal conductivity. In this case, reactions requiring thermal cycles such as a polymerase chain reaction (PCR) can be performed rapidly and reliably using the valve unit 40A.

The valve substance (V) includes a phase change material that is non-fluidic (e.g., solid) at ambient temperature, and a number of fine thermal particles uniformly dispersed throughout the phase change material. The thermal particles generate heat when energy is applied to them. It should be understood that the term "fluidic" as employed herein refers to the condition that the valve substance (V) or the phase change material can move or flow along the channels or from the chamber /container to the channel, and vice versa. The flow may be caused by centrifugal force generated by rotations of the microfluidic substrate. The term "non-fluidic" as employed herein refers to the condition that the valve substance (V) or the phase change material does not move or flow due to its lowered viscosity and hardens enough to effectively block a flow of fluid in the channel even when the microfluidic substrate rotates.

The phase change material can be wax. The wax melts into a fluid and increase in volume, when heat is applied to the wax. For example, the wax can be paraffin wax, microcrystalline wax, synthetic was, or natural wax.

Alternatively, the phase change material can be a gel or a thermoplastic resin. For example, the gel may be polyacrylamide, polyacrylate, polymethacrylate, or polyvinylamide. The thermoplastic resin may be cyclic olefin copolymer(COC), polymethylmethacrylate(PMMA), polycarbonate(PC), polystyrene(PS), polyoxymethylene(POM), perfluoralkoxy(PFA), polyvinylchloride(PVC), polypropylene(PP), polyethylene terephthalate(PET), polyetheretherketone(PEEK), polyamide(PA), polysulfone(PSU), or polyvinylidene fluoride(PVDF).

The fine thermal particles have a diameter in the range of 1 nm to 100 µm, such that the fine thermal particles can freely pass through the channel 35 and the valve connection path 44A. The fine thermal particles rapidly increase in temperature and emit heat when energy is supplied to them. The energy sources may be, for example, laser light irradiation. Further, the fine thermal particles can be uniformly dispersed throughout the wax. The fine thermal particles may have a structure that has a metallic core and a hydrophobic surface covered on the core. For example, the thermal particles can have a molecular structure including a Fe core and a layer of surfactants coupled to the Fe core and surrounding the Fe core.

Usually, the fine thermal particles are available and employed as a dispersion in a carrier oil. The carrier oil may be hydrophobic so as to allow the hydrophobic fine thermal particles to be dispersed uniformly therein. The valve substance (V) can be manufactured by mixing wax with a carrier oil dispersion of the fine thermal particles. In the above description, the fine thermal particles have a polymer type particle structure. However, the fine thermal particles may have other particle structures such as a quantum dot structure or a magnetic bead structure.

FIG. 4 is a temperature-time graph for the case when a laser light is projected onto pure paraffin wax and paraffin wax containing fine thermal particles that emit heat. FIG. 4 shows the melting point with respect to the lapse of the time, measured for the pure paraffin wax and the paraffin wax containing the fine thermal particles according to an embodiment of the present invention.

Referring to FIG. 4, a solid line denotes a temperature curve of 100% pure paraffin wax. A dashed line denotes a temperature curve of 50% (v/v) paraffin wax-50%(v/v) fine thermal particles. The 50% (v/v) paraffin wax-50%(v/v) fine thermal particles is also known as 50% impurity paraffin wax, and is a 1:1 mixture of pure paraffin wax and a carrier oil dispersion of 10-nm fine thermal particles. A phantom line (long dashed double-short-dashed line) denotes a temperature curve of 20% impurity paraffin wax. The 20% impurity paraffin wax is a 4:1 mixture of pure paraffin wax and a carrier oil dispersion of 10-nm fine thermal particles. An 808-nm wavelength laser is used for the experiment of FIG. 4. Pure paraffin wax melts at about 68°C to 74°C. Referring to FIG. 4, when laser light is irradiated to the pure paraffin wax, the pure paraffin wax reaches its melting point after 20 sec or more (refer to (ii) in FIG. 4). On the other hand, the 50% impurity paraffin wax and the 20% impurity paraffin wax are rapidly heated by laser light irradiation and reach their melting points within about 5 sec after the laser light irradiation (refer to (i) in FIG. 4).

The fine thermal particles can include a ferromagnetic material such as Fe, Ni, Co, or an oxide thereof. Further, the fine thermal particles can include a metal oxide such as Al₂O₃, TiO₂, Ta₂O₃, Fe₂O₃, Fe₃O₄, or HfO₂.

Referring again to FIGS. 2A through 2F, the laser light source 50 can include a laser diode. A laser light source capable of emitting pulsed laser light at an energy rate of 1 mJ/pulse or higher, or a laser light source capable of emitting continuous wave laser light at a power of 10 mW or greater can be used as the laser source 50 in the current embodiment of the present invention. The laser light source 50 is provided in a way to allow its free movement in a precisely controlled manner above the substrate so that it can irradiate laser light to an exact target point of the substrate. For example, although not shown in FIGS. 2A through 2F, the valve unit 40A can further include a collimating unit for adjusting the irradiation direction and area irradiated by laser light (L). Further, the valve unit 40A may include additional external laser light source (not shown). The collimating unit can include at least one lens and at least one mirror.

Referring to FIG. 2A, when the laser light (L) is irradiated for a short time to the valve substance (V), which is in non-fluidic phase (i.e., hardened) inside the valve substance container 42A using the laser light source 50, the valve substance (V) rapidly expands while changing into a fluidic phase (i.e., melted phase). Thus, the fluidic (i.e., melted) valve substance (V) flows into the channel 35 through the valve connection path 44A. The fluidity of the fluidic valve substance (V) increases as it flows into the channel. Referring to FIG. 2B, in the channel 35, the valve substance (V) stays between the drain chambers 46 and 47 due to its reduced fluidity and surface tension, and thus the channel 35 is closed. As a result, fluid (F) cannot flow along the channel 35. Some of the valve substance (V) may be introduced in the drain chambers 46 and 47.

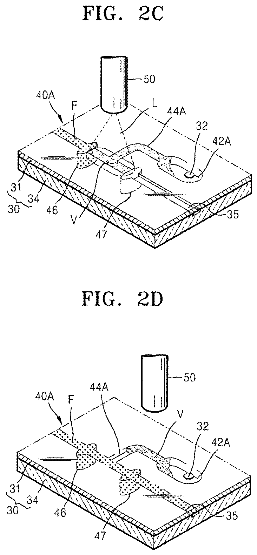

Referring to FIG. 2C, when the laser light (L) is irradiated to the valve substance (V), which now is filled in the channel 35 between the drain chambers 46 and 47 and thus blocks the channel 35, for a short time using the laser light source 50, the valve substance (V) rapidly expands while melting and is removed from the channel 35. As the amount of the valve substance (V), which blocks the channel 35 in its non-fluidic phase, is small and the melted valve substance (V) may be introduced into the fluid F. Thus, as shown in FIG. 2D, the channel 35 is opened again to allow the fluid (F) to flow along the channel 35.

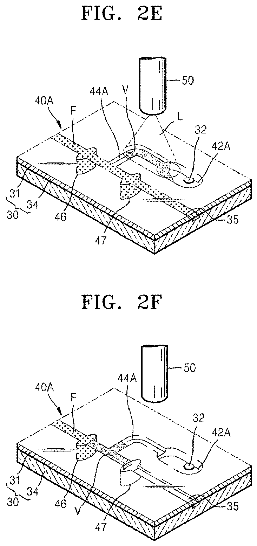

Referring to FIG. 2E, when the laser light (L) is irradiated to the hardened valve substance (V) remaining in the valve substance container 42A and the valve connection path 44A for a short time using the laser light source 50, the valve substance (V) explosively expands while melting, flows into the channel 35, and hardens in the channel 35. Thus, as shown in FIG. 2F, the channel is closed again. In this way, the channel 35 can be iteratively closed and opened by repeatedly irradiating the laser light (L). Thus, according to the present invention, it is possible to close and open a channel using a valve substance, by adjusting the initial amount of the valve substance contained in the container 42A and the amount of the valve substance which is melted and used to block the channel, which can be done by adjusting the condition of the laser light irradiation and the temperature-melting point properties of the valve substance and the distance of the valve connection path 44A.

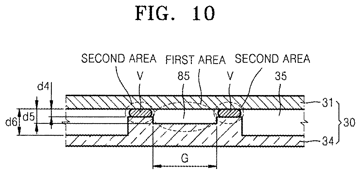

Even though embodiments of valve units having drain chambers have been explained and illustrated, the present disclosure also relates to valve units without drain chambers. For example, a valve unit may include a fluid channel which has a greater dimension than the valve area (i.e., the location of the fluid channel where non-fluidic valve material blocks the flow of a fluid). An cross sectional view of an exemplary valve unit without drain chambers is shown in FIG. 10. As shown in FIG. 10, the intersection area 85 has a dimension "d5," and the valve area where valve material V is solidified and blocks the channel has a dimension "d4," and the channel 35 has a dimension "d6." The microfluidic device 30 also has a upper plate 31 and a lower plate 34. The connection path (not shown) is fluid connected to the intersection area 85 so that the valve substance in the valve substance container (not shown) can flow from the container (not shown) to the intersection area 85 ("first area" in Fog. 10) through the connection path (not shown), and to the channel 35. The first area (or intersection area) 85 is formed in the channel and has a dimension "d5". The valve unit also has a pair of second areas of a dimension ("d4"), which are formed in the channel and spaced from each other with a gap ("G"). The dimension d5 of the first area (or intersection area) 85 is larger than the dimension d4 of the second areas, and the dimension of the channel 35 is greater than the dimension d4 of the second areas. When energy is applied to the valve substance contained in the valve substance container (not shown), the valve substance becomes fluidic and at least portion of the valve substance flows to the channel 35 through the valve connection path (not shown), and the portion of the valve substance flowed into the channel becomes non-fluidic and blocks the channel at the second areas; and when energy is applied to the portion of the valve substance blocking the channel, the portion of the valve substance becomes fluidic, resulting in opening the channel.

A valve unit of such a structure is explained in more detail in a commonly assigned co-pending US20080042096. The valve unit described in US20080042096 may be modified to have a valve substance container and a valve connection path.

Referring to FIG. 3, a valve unit 40B is illustrated according to another embodiment of the present invention. In the valve unit 40B, a valve connection path 44B connecting a valve substance container 42B and a channel 35 is straight unlike the curved valve connection path 44A of the embodiment illustrated in FIGS. 2A through 2F. That is, the valve connection path 44B of the current embodiment is relatively short. Thus, the valve unit 40B can be reduced in size and integrated more highly. However, in the current embodiment, the irradiation direction and area irradiated by the laser light (L) need to be controlled more precisely than in the valve unit 40A of the embodiment illustrated in FIGS. 2A through 2F.

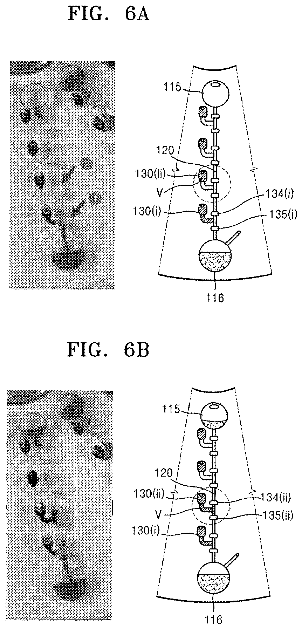

FIG. 5 is a perspective view illustrating a microfluidic device 100 including the valve unit 40A depicted in FIGS. 2A through 2F, according to an embodiment of the present invention, and FIGS. 6A through 6C are photographic images illustrating operation test results of the microfluidic device 100 depicted in FIG. 5, according to an embodiment of the present invention.

Referring to FIG. 5, the fluid treating apparatus of the current embodiment includes a compact disk (CD) type substrate 110, a spindle motor 105 which rotates the substrate 110, and a laser light source 150 irradiating laser light (L) toward the substrate 110. The substrate 110 includes upper and lower plates 111 and 114 bonded together. Channels 120 are formed in the lower plate 114 in a radially arranged fashion. First fluid chambers 115 are formed in a center portion of the substrate 110 and connected to a first end of the channels 120, respectively. Second fluid chambers 116 are formed along the circumference of the substrate 110 and are connected to a second end of the channels 120, respectively.

A plurality of valve substance containers 130 are formed along each of the channels 120. A plurality of valve connection paths 132 are formed along each of the channels 120 to connect the valve substance containers 130 and the channel 120. A plurality of pairs of drain chambers 134 and 135 are formed along each of the channels 120 at both sides of the valve connection paths 132. The valve substance container 130, the valve connection path 132, a pair of the drain chambers 134 and 135, the laser light source 150 are included in a valve unit (refer to FIG. 2A). Reference numeral 113 denotes fluid injection holes formed in the upper plate 111 to introduce a fluid (e.g., blood samples or reaction solutions) into the first fluid chambers 115.

Referring to FIG. 6A, laser light is irradiated to a first valve substance container 130(i) that is nearest to the second fluid chamber 116 so as to close the channel 120 using a valve substance (V). Then, laser light is irradiated to a portion of the channel 120 between a pair of drain chambers 134(i) and 135(i) so as to open the channel 120 again. A photographic image of this state, a photograph is shown in FIG. 6A. After introducing a fluid into the first fluid chamber 115, the substrate 110 (refer to FIG. 5) is rotated several times. Then, the fluid is moved from the first fluid chamber 115 to the second fluid chamber 116 through the channel 120. This shows that the channel 120 is opened.

Referring to FIG. 6B, laser light is irradiated to a second valve substance container 130(ii) that is second nearest to the second fluid chamber 116 so as to close the channel 120 using a valve substance (V). A photographic image of this state is shown in FIG. 6B. After introducing a fluid again into the first fluid chamber 115, the substrate 110 is rotated several times. However, the fluid is not moved from the first fluid chamber 115 to the second fluid chamber 116 through the channel 120. This shows that the channel 120 is closed.

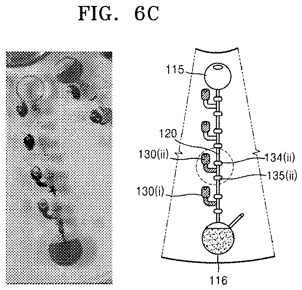

Referring to FIG. 6C, laser light is irradiated to a portion of the channel 120 between a pair of drain chambers 134(ii) and 135(ii) that are near to the second valve substance container 130(ii) so as to open the channel 120 again. A photographic image of this state is shown in FIG. 6C. Then, the substrate 110 is rotated several times. As a result, the fluid in the first fluid chamber 115 is moved to the second fluid chamber 116 through the channel 120, and thus the fluid level of the second fluid chamber 116 is increased. This shows that the channel 120 is opened again.

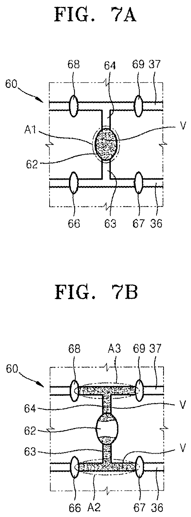

FIGS. 7A through 7E are plan views for explaining an operation of a valve unit 60 according to another embodiment of the present invention.

Referring to FIGS. 7A through 7E, the valve unit 60 of the current embodiment includes a valve substance container 62, a valve substance (V) contained in the valve substance container 62, a pair of valve connection paths 63 and 64 connecting a pair of channels 36 and 37 to the valve substance container 62, and two pairs of drain chambers 66, 67, 68, and 69. The drain chambers 66 and 67 are spaced each other and formed along the channel 36. The valve connection path 63 is fluid connected to the channel 36 between the drain chamber 66 and the drain chamber 67. Likewise, The drain chambers 68 and 69 are spaced each other and formed along the channel 37. The valve connection path 64 is fluid connected to the channel 37 between the drain chamber 68 and the drain chamber 69. The valve unit 60 further includes an external laser light source (refer to FIG. 2A) so as to supply energy to the valve substance (V). The valve substance (V) and the laser light source are described in detail with reference to FIGS. 2A through 2F. Thus, descriptions thereof will be omitted.

Referring to FIG. 7A, laser light is irradiated for a short time to the valve substance (V), which is in non-fluidic phase (i.e., solid or hardened) inside the valve substance container 62. Reference character A1 denotes an area irradiated by the laser light. Then, referring to FIG. 7B, the valve substance (V) rapidly expands while changing in its fluidic phase (i.e., melting) and thus flows into the channels 36 and 37 through the pair of valve connection paths 63 and 64. The valve substance (V) introduced into the channels 36 and 37 further flows by the capillary phenomenon and hardens in the channels 36 and 37, thereby closing the channels 36 and 37. As a result, part of the valve substance (V), which is in its fluidic phase, may be introduced into the drain chambers 66, 67, 68, and 69.

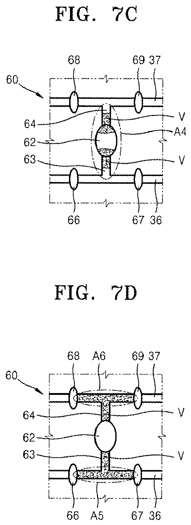

Laser light is irradiated again for a short time to the non-fluidic (hardened) valve substance (V) in the channels 36 and 37 between the drain chambers 66, 67, 68, and 69. In FIG. 7B, reference characters A2 and A3 each denote irradiation areas of the laser light. As described above, then, the valve substance (V) expands instantly while melting and is removed from the channels 36 and 37. Thus, as shown in FIG. 7C, the channels 36 and 37 are opened again, and fluid (F) can flow along the channels 36 and 37.

Thereafter, laser light is irradiated again for a short time to the remainder of the non-fluidic (hardened) valve substance (V) in the valve substance container 62 and the valve connection paths 63 and 64. Reference character A4 denotes an area irradiated by the laser light. Then, as shown in FIG. 7D, the valve substance instantly expands while melting and flows into the channels 36 and 37. The valve substance (V) stays the channels 36 and 37 and hardens, and thus the channels 36 and 37 are closed again.

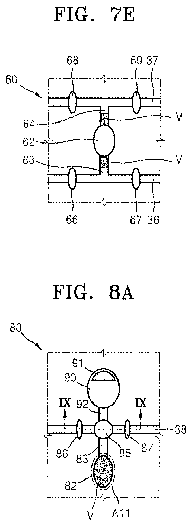

Laser light is irradiated again for a short time to the non-fluidic (hardened) valve substance (V) in the channels 36 and 37 between the drain chambers 66, 67, 68, and 69. In FIG. 7D, reference characters A5 and A6 denote areas irradiated by the laser light. Then, the valve substance (V) instantly expands while melting and is removed from the channels 36 and 37. Thus, as shown in FIG. 7E, the channels 36 and 37 are opened again. In this way, the channels 36 and 37 can be repeatedly closed and opened by adjusting the initial amount of the valve substance contained in the container 62 and the amount of the valve substance which is melted and used to block the channel, which can be done by adjusting the condition of the laser light irradiation and the temperature-melting point properties of the valve substance and the distance of the valve connection paths 64 and 63.

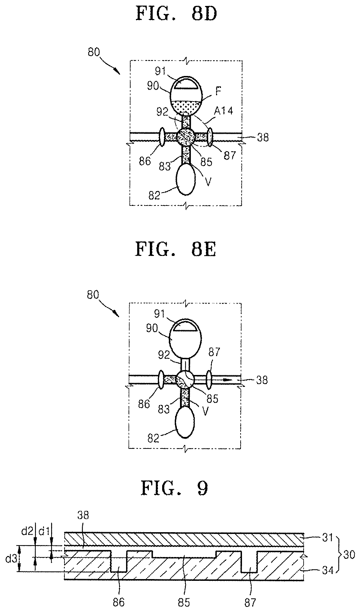

FIGS. 8A through 8E are plan views for explaining an operation of a valve unit 80 according to another embodiment of the present invention, and FIG. 9 is a sectional view taken along line IX-IX of FIG. 8A for explaining the operation of the valve unit, according to an embodiment of the present invention.

Referring to FIGS. 8A through 8E and 9, the valve unit 80 according to the current embodiment of the present invention includes a valve substance container 82, a valve substance (V) filled in the valve substance container 82, a valve connection path 83 connecting a channel 38 and the valve substance container 82, a pair of drain chambers 86 and 87, each spaced from the other and formed along the channel 83, and a laser light source (refer to FIG. 2A) supplying energy to the valve substance (V). An intersection groove 85 is formed at an intersection point where the valve connection path 83 and the channel 38 meet. The depth ("d2") of the intersection groove 85 is not greater than the depth ("d3") of the drain chambers 86 and 87 but larger than that ("d1") of the channel 38.

In the current embodiment, the valve unit 80 further includes a fluid chamber 90 for containing fluid and a fluid connection path 92 connecting the fluid chamber 90 and the intersection groove 85. The valve substance container 82, the channel 38, the valve connection path 83, the drain chambers 86 and 87, the fluid connection path 92, and the intersection groove 85 are formed in a lower plate 34 of a substrate 30. Reference numeral 91 denotes a fluid injection hole formed in an upper plate 31 for introducing fluid into the fluid chamber 90. Meanwhile, since the valve substance (V) and the laser light source are described in detail with reference to FIGS. 2A through 2F, descriptions thereof will be omitted.

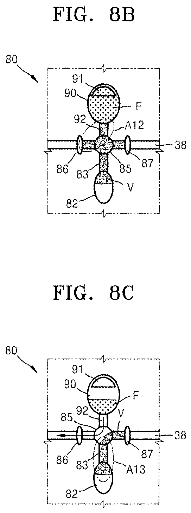

Referring to FIG. 8A, laser light is irradiated for a short time to the valve substance (V), which is in its non-fluidic phase (i.e., hardened) inside the valve substance container 82. Reference character A11 denotes an area irradiated by the laser light. Then, as shown in FIG. 8B, the valve substance (V) instantly expands while melting and thus flows into the intersection groove 85, the channel 38, and the fluid connection path 92 through the valve connection path 83. The valve substance (V) introduced into the intersection groove 85 and the channel 38 further flows by the capillary phenomenon and hardens in the intersection groove 85 and the channel 38. Therefore, the channel 38 is closed. Some of the valve substance (V) can be filled into the drain chambers 86 and 87. Part of the valve substance (V) may be introduced into the fluid connection path 92 and hardens therein. Here, when fluid (F) is injected into the fluid chamber 90, the fluid (F) cannot flow to the channel 38 since the fluid connection path 92 is closed.

Laser light is irradiated for a short time to a portion of the intersection groove 85, the fluid connection path 92, and a portion of the channel 38 between the intersection groove 85 and the left drain chamber 86. In FIG. 8B, reference characters A12 denotes an area irradiated by the laser light. Then, the valve substance (V) hardened in the area A12 melts again and expands explosively. Therefore, as shown in FIG. 8C, the left side of the channel 38 to the fluid connection path 92 and the intersection groove 85 can be opened to allow the fluid (F) to flow from the fluid chamber 90 to the left side of the channel 38 as indicated by the arrow.

Thereafter, laser light is irradiated again for a short time to the hardened valve substance (V) in the valve substance container 82 and the valve connection paths 83. Reference character A13 denotes an area irradiated by the laser light. Then, as shown in FIG. 8D, the valve substance (V) instantly expands while melting and flows into the intersection groove 85, a portion of the channel 38 between the intersection and the left drain chamber 86, and the fluid connection path 92. In this state, the valve substance (V) hardens, and thus the fluid (F) in the fluid chamber 90 cannot flow into the channel 38.

In this time, laser light is irradiated for a short time to the hardened valve substance (V) in a portion of the channel 38 between the intersection groove 85 and the right drain chamber 87, the fluid connection path 92, and a portion of the intersection groove 85. In FIG. 8D, reference characters A14 denotes an area irradiated by the laser light. Then, the valve substance (V) in the area A14 melts again and expands instantly. Therefore, as shown in FIG. 8E, the right side of the channel 38 to the fluid connection path 92 and the intersection groove 85 can be opened to allow the fluid (F) to flow from the fluid chamber 90 to the right side of the channel 38 as indicated by the arrow. According to the current embodiment of the present invention, the flow of fluid can be controlled in a desired direction using the valve unit 80.

Meanwhile, according to another embodiment of the present invention, a valve unit can close and open a channel by supplying energy to a valve substance formed of a phase change material without fine thermal particles. Further, a microfluidic device employing the valve unit can be provided.

According to the present invention, a channel can be opened and closed using only a single valve unit. Therefore, a compact and highly integrated fluid reaction substrate can be provided. Furthermore, the costs and time required for manufacturing a fluid reaction substrate can be reduced.

In addition, a channel can be opened and closed a plurality of times using the valve unit. As a result, a fluid reaction substrate can have a simple fluid passage, and thus it is easy to design a fluid reaction substrate. In addition, a fluid reaction substrate is reusable.

While the present invention has been particularly shown and described with reference to exemplary embodiments thereof, it will be understood by those of ordinary skill in the art that various changes in form and details may be made therein.

## Claims

1. A valve unit (40A, B, 60, 80) comprising:
a channel (35, 36, 37) which forms a fluid passage;
a first drain chamber (46, 66, 68) formed along the channel;
a valve substance (V) including a phase change material that is non-fluidic at ambient temperature and fluidic when energy is applied thereto;
a valve substance container (42A, B, 62, 82) which contains the valve substance; and
a valve connection path (44A, B, 63, 64) which connects the valve substance container (42A, B, 62, 82) to the channel (35, 36, 37), **characterised in that** a second drain chamber (47, 67, 69) is formed along the channel, the first and the second drain chambers being spaced from each other wherein the connection point of the channel (35, 36, 37) where the valve connection path meets the channel is located between the first drain chamber (46, 66, 68) and the second drain chamber (47, 67, 69), and wherein when energy is applied to the valve substance contained in the valve substance container, the valve substance expands and becomes fluidic and a portion of the valve substance flows to the channel through the valve connection path, and the portion of the valve substance flowed in the channel becomes non-fluidic and blocks the channel; and when energy is applied to the portion of the valve substance blocking the channel, the portion of the valve substance becomes fluidic and discharged to the first drain chamber and the second drain chamber to open the channel.

2. The valve unit of claim 1, wherein the energy is pulsed electromagnetic waves having an energy rate of at least 1 mJ/pulse or continuous electromagnetic waves having a power of at least 10 mW.

3. The valve unit of claim 1, wherein the energy is a laser light having a wavelength in a range of 750 nm to 1300 nm, infrared light or a gas with a temperature at which the phase change material can be melted to a fluidic state.

4. The valve unit of claim 1, wherein the valve substance (V) further comprises thermal particles, which emit heat when energy is applied thereto are dispersed in the phase change material.

5. The valve unit of claim 4, wherein the thermal particles have a diameter in a range of 1 nm to 100 µm and comprise a ferromagnetic material or a metal oxide selected from the group consisting of Al2O3, TiO2, Ta2O3, Fe2O3, Fe3O4and HfO2.

6. The valve unit of claim 4, wherein the thermal particles are polymer particles, quantum dots, or magnetic beads.

7. The valve unit of claim 6, wherein the magnetic beads comprise at least one component selected from the group consisting of Fe, Ni, Cr, and an oxide thereof.

8. The valve unit of claim 1, wherein the phase change material is one or more of wax selected from the group consisting of paraffin wax, microcrystalline wax, synthetic wax, natural wax and mixtures thereof; a gel selected from the group consisting of polyacrylamide, polyacrylate, polymethacrylate, polyvinylamide and mixtures thereof; and a thermoplastic resin selected from the group consisting of cyclic olefin copolymer(COC), polymethylmethacrylate(PMMA), polycarbonate(PC), polystyrene(PS), polyoxymethylene(POM), perfluoralkoxy(PFA), polyvinylchloride(PVC), polypropylene(PP), polyethylene terephthalate(PET), polyetheretherketone(PEEK), polyamide(PA), polysulfone(PSU), polyvinylidene fluoride(PVDF) and mixtures thereof.

9. The valve unit of claim 1, wherein the valve substance container (62) is connected to a plurality of separate channels (36, 37) each through a valve connection path (63, 64), each of the channels (36, 37) forming the fluid passage and provided with the first drain chamber (66, 68) and the second drain chamber (67, 69).

10. The valve unit of claim 1, further comprising: a fluid chamber (90) which contains a fluid; and a fluid connection path (92) which connects the fluid chamber (90) to the valve substance container (82) at the connection point of the channel (38), wherein when energy is applied to the valve substance (V) contained in the valve substance container (82), the valve substance becomes fluidic and at least portion of the valve substance flows to the channel and to the fluid connection path through the valve connection path, and the portion of the valve substance flowed in the channel and the fluid connection path becomes non-fluidic and blocks the channel and the fluid connection path; and when energy is applied to the portion of the valve substance blocking the channel and the fluid connection path, the portion of the valve substance becomes fluidic and discharged to the drain chambers to open the channel and the fluid connection path.

11. A microfluidic device (100) comprising a substrate (110) which comprises at least one valve unit according to one of the previous claims.

12. The microfluidic device of claim 11, wherein the substrate (110) comprises a plurality of channels (120), and the valve substance container (130) is connected to the plurality of channels (120) each through a separate valve connection path (132), each of the channels forming the fluid passage and provided with the first drain chamber and the second drain chamber.

13. The microfluidic device of claim 11, wherein at least a portion of the substrate (110) is transparent so as to allow the electromagnetic waves to propagate through the substrate.

14. The microfluidic device of claim 11, further comprising an actuating unit (105) rotating the substrate, wherein the fluid is pumped by a centrifugal force generated when the actuating unit rotates the substrate.

## Patentansprüche

1. Ventileinheit (40A, B, 60, 80), welche aufweist:
einen Kanal (35, 36, 37), welcher eine Fluidpassage bildet;
eine erste Abflusskammer (46, 66, 68), die entlang des Kanals gebildet ist;
eine Ventilsubstanz (V), welche ein Phasenänderungsmaterial enthält, das fest bei Umgebungstemperatur und flüssig bei zugeführter Energie ist;
einen Ventilsubstanzbehälter (42A, B, 62, 82), welcher die Ventilsubstanz enthält, und
einen Ventilverbindungspfad (44A, B, 63, 64), welcher den Ventilsubstanzbehälter (42A, B, 62, 82) mit dem Kanal (35, 36, 37) verbindet,
**dadurch gekennzeichnet, dass**
eine zweite Abflusskammer (47, 67, 69) entlang des Kanals gebildet ist, wobei erste und zweite Abflusskammern voneinander beabstandet sind und der Verbindungspunkt des Kanals (35, 36, 37), wo der Ventilverbindungspfad den Kanal trifft, zwischen der ersten Abflusskammer (46, 66, 68) und der zweiten Abflusskammer (47, 67, 69) angeordnet ist, wobei, wenn Energie der in dem Ventilsubstanzbehälter enthaltenen Ventilsubstanz zugefügt wird, die Ventilsubstanz expandiert und flüssig wird sowie ein Teil der Ventilsubstanz zu dem Kanal durch den Ventilverbindungspfad fließt, wobei der Teil der in den Kanal geflossenen Ventilsubstanz aushärtet und den Kanal blockiert und wenn Energie zu dem Teil der Ventilsubstanz, die den Kanal blockiert, zugeführt wird, dieser Teil der Ventilsubstanz flüssig wird und zu der ersten Abflusskammer und zu der zweiten Abflusskammer ausgegeben wird, um den Kanal zu öffnen.

2. Ventileinheit nach Anspruch 1, wobei die Energie eine gepulste elektromagnetische Schwingung mit einer Energierate von wenigstens 1 mJ/Puls oder eine kontinuierliche elektromagnetische Schwingung mit einer Leistung von wenigstens 10 mW ist.

3. Ventileinheit nach Anspruch 1, wobei die Energie ein Laserlicht mit einer Wellenlänge in einem Bereich von 750 nm bis 1300 nm, Infrarotlicht oder ein Gas mit einer Temperatur ist, bei welcher das Phasenänderungsmaterial in einen flüssigen Zustand schmelzbar ist.

4. Ventileinheit nach Anspruch 1, wobei die Ventilsubstanz (V) weiterhin thermische Partikel enthält, welche Wärme abgeben, wenn Energie zugeführt wird, welche Partikel in dem Phasenänderungsmaterial fein verteilt sind.

5. Ventileinheit nach Anspruch 4, wobei die thermischen Partikel einen Durchmesser im Bereich von 1 nm bis 100µm aufweisen und ein ferromagnetisches Material oder ein Metalloxid enthalten, welches aus der Gruppe mit Al2O3, Ti02, Ta2O3, Fe2O3, Fe3O4 und HfO2 ausgewählt ist.

6. Ventileinheit nach Anspruch 4, wobei die thermischen Partikel Polymerpartikel, Quantendots oder magnetische Kügelchen sind.

7. Ventileinheit nach Anspruch 6, wobei die magnetischen Kügelchen wenigstens eine Komponente aus der Gruppe bestehend aus Fe, Ni, Cr oder einem ihrer Oxide enthalten.

8. Ventileinheit nach Anspruch 1, wobei das Phasenänderungsmaterial aus einem oder mehreren Wachsen, ausgewählt aus der Gruppe bestehend aus Paraffinwachs, mikrokristallinem Wachs, synthetischem Wachs, natürlichem Wachs oder Mischungen aus denselben; einem Gel ausgewählt aus der Gruppe bestehend aus Polyacrylamid, Polyacrylat, Polymethacrylat, Polyvinylamid oder Mischungen aus denselben, und einem thermoplastischen Kunststoff, ausgewählt aus der Gruppe bestehend aus zyklischen Olefin-Copolymeren (COC), Polymethylmethacrylat (PMMA), Polycarbonat (PC), Polystyren (PS), Polyoxymethylen (POM), Perfluoralkoxy (PFA), Polyvinylchlorid (PVC), Polypropylen (PP), Polyethylenterephthalat (PET), Polyetheretherketon (PEEK), Polyamid (PA), Polysulfon (PSU), Polyvinyliden Fluorid (PVDF) oder Mischungen aus denselben ausgewählt ist.

9. Ventileinheit nach Anspruch 1, wobei der Ventilsubstanzbehälter (62) mit einer Vielzahl von getrennten Kanälen (36, 37) über jeweils einen Ventilverbindungspfad (63, 64) verbunden ist, wobei jeder der Kanäle (36, 37) die Fluidpassage bildet und mit der ersten Abflusskammer (66, 68) und der zweiten Abflusskammer (67, 69) ausgebildet ist.

10. Ventileinheit nach Anspruch 1, welche weiterhin aufweist:
eine Fluidkammer (90), welche ein Fluid enthält, und
einen Fluidverbindungspfad (92), der die Fluidkammer (90) mit dem Ventilsubstanzbehälter (82) an dem Verbindungspunkt des Kanals (38) verbindet, wobei, wenn Energie der Ventilsubstanz (V) zugeführt wird, die in dem Ventilsubstanzbehälter (82) enthalten ist, die Ventilsubstanz flüssig wird und wenigstens ein Teil der Ventilsubstanz zu dem Kanal und dem Fluidverbindungskanal durch den Ventilverbindungspfad fließt, und der Teil der Ventilsubstanz, der in den Kanal und den Fluidverbindungspfad geflossen ist fest wird und den Kanal und den Fluidverbindungspfad blockiert, und, wenn Energie zu diesem Bereich der den Kanal und den Fluidverbindungskanal blockierenden Ventilsubstanz zugeführt wird, dieser Bereich der Ventilsubstanz flüssig wird und zu den Abflusskammern abgeführt wird, um den Kanal und den Fluidverbindungspfad zu öffnen.

11. Mikrofluidvorrichtung (100) mit einem Substrat (110), welches wenigstens eine Ventileinheit gemäß einem der vorangehenden Ansprüche aufweist.

12. Mikrofluidvorrichtung nach Anspruch 11, wobei das Substrat (110) eine Vielzahl von Kanälen (120) aufweist und der Ventilsubstanzbehälter (130) mit der Vielzahl von Kanälen (120) jeweils über einen getrennten Ventilverbindungspfad (132) verbunden ist, wobei jeder der Kanäle die Fluidpassage bildet und mit erster Abflusskammer und zweiter Abflusskammer ausgebildet ist.

13. Mikrofluidvorrichtung nach Anspruch 11, wobei wenigstens ein Teil des Substrats (110) transparent ist, so dass elektromagnetische Wellen durch das Substrat hindurchtreten können.

14. Mikrofluidvorrichtung nach Anspruch 11, welche weiterhin eine Betätigungseinheit (105) zum Drehen des Substrats aufweist, wobei das Fluid durch eine Zentrifugalkraft gepumpt wird, wenn die Betätigungseinheit das Substrat dreht.

## Revendications

1. Unité de vanne (40A, B, 60, 80) comprenant :
un canal (35, 36, 37) qui forme un passage de fluide ;
une première chambre de drainage (46, 66, 68) formée le long du canal ;
une substance de vanne (V) incluant un matériau à changement de phase qui est non fluide à température ambiante et fluide lorsque de l'énergie lui est appliquée ;
un récipient de substance de vanne (42A, B, 62, 82) qui contient la substance de vanne ; et
un chemin de connexion de vanne (44A, B, 63, 64) qui connecte le récipient de substance de vanne (42A, B, 62, 82) au canal (35, 36, 37),
**caractérisée en ce qu'**une deuxième chambre de drainage (47, 67, 69) est formée le long du canal, les première et deuxième chambres de drainage étant espacées entre elles, dans laquelle le point de connexion du canal (35, 36, 37) où le chemin de connexion de vanne rejoint le canal est situé entre la première chambre de drainage (46, 66, 68) et la deuxième chambre de drainage (47, 67, 69), et dans laquelle, quand de l'énergie est appliquée à la substance de vanne contenue dans le récipient de substance de vanne, la substance de vanne se dilate et devient fluide et une portion de la substance de vanne s'écoule vers le canal à travers le chemin de connexion de vanne, et la portion de la substance de vanne qui s'est écoulée dans le canal devient non fluide et bloque le canal ; et quand de l'énergie est appliquée à la portion de la substance de vanne qui bloque le canal, la portion de la substance de vanne devient fluide et est déchargée vers la première chambre de drainage et la deuxième chambre de drainage pour ouvrir le canal.

2. Unité de vanne selon la revendication 1, dans laquelle l'énergie consiste en des ondes électromagnétiques pulsées ayant un taux d'énergie d'au moins 1 mJ/impulsion, ou en des ondes électromagnétiques continues ayant une puissance d'au moins 10 mW.

3. Unité de vanne selon la revendication 1, dans laquelle l'énergie est une lumière laser ayant une longueur d'onde dans une plage de 750 nm à 1300 nm, une lumière infrarouge, ou un gaz ayant une température à laquelle le matériau à changement de phase peut être fondu pour passer à l'état fluide.

4. Unité de vanne selon la revendication 1, dans laquelle la substance de vanne (V) comprend en outre des particules thermiques qui émettent de la chaleur lorsque de l'énergie leur est appliquée, dispersées dans le matériau à changement de phase.

5. Unité de vanne selon la revendication 4, dans laquelle les particules thermiques ont un diamètre compris dans une plage de 1 nm à 100 µm et comprennent un matériau ferromagnétique ou un oxyde métallique sélectionné dans le groupe constitué par Al₂O₃, TiO₂, Ta₂O₃, Fe₂O₃, Fe₃O₄ et HfO₂.

6. Unité de vanne selon la revendication 4, dans laquelle les particules thermiques sont des particules de polymère, des boîtes quantiques ou des billes magnétiques.

7. Unité de vanne selon la revendication 6, dans laquelle les billes magnétiques comprennent au moins un composant sélectionné dans le groupe constitué par Fe, Ni, Cr, ainsi que les oxydes de ceux-ci.

8. Unité de vanne selon la revendication 1, dans laquelle le matériau à changement de phase est un ou plusieurs matériaux parmi une cire sélectionnée parmi le groupe constitué par la cire paraffine, la cire microcristalline, la cire synthétique et la cire naturelle, ainsi que les mélanges de celles-ci ; un gel sélectionné parmi le groupe constitué par le polyacrylamide, le polyacrylate, le polyméthacrylate et le polyvinylamide, ainsi que les mélanges de ceux-ci ; et une résine thermoplastique sélectionnée parmi le groupe constitué par les copolymères d'oléfine cyclique (COC), le polyméthacrylate de méthyle (PMMA), le polycarbonate (PC), le polystyrène (PS), le polyoxyméthylène (POM), perfluoroalkoxy (PFA), le polychlorure de vinyle (PVC), le polypropylène (PP), le polytéréphtalate d'éthylène (PET), le polyétheréthercétone (PEEK), le polyamide (PA), les polysulfones (PSU) et le polyfluorure de vinylidène (PVDF), ainsi que les mélanges de ceux-ci.

9. Unité de vanne selon la revendication 1, dans laquelle le récipient de la substance de vanne (62) est connecté à une pluralité de canaux séparés (36, 37), chacun via un chemin de connexion de vanne (63, 64), chacun des canaux (36, 37) formant le passage de fluide et étant pourvu de la première chambre de drainage (66, 68) et de la deuxième chambre de drainage (67, 69).

10. Unité de vanne selon la revendication 1, comprenant en outre : une chambre de fluide (90) contenant un fluide ; et un chemin de connexion de fluide (92) qui connecte la chambre de fluide (90) au récipient de substance de vanne (82) au point de connexion du canal (38), dans laquelle, lorsque de l'énergie est appliquée à la substance de vanne (V) contenue dans le récipient de substance de vanne (82), la substance de vanne devient fluide et au moins une portion de la substance de vanne s'écoule vers le canal et vers le chemin de connexion de fluide à travers le chemin de connexion de vanne, et la portion de la substance de vanne qui s'est écoulée dans le canal et le chemin de connexion de fluide devient non fluide et bloque le canal et le chemin de connexion de fluide ; et lorsque de l'énergie est appliquée à la portion de la substance de vanne qui bloque le canal et le chemin de connexion de fluide, la portion de la substance de vanne devient fluide et est déchargée vers les chambres de drainage pour ouvrir le canal et le chemin de connexion de fluide.

11. Dispositif microfluidique (100) comprenant un substrat (110) qui comporte au moins une unité de vanne selon l'une des revendications précédentes.

12. Dispositif microfluidique selon la revendication 11, dans lequel le substrat (110) comprend une pluralité de canaux (120), et le récipient de la substance de vanne (130) est connecté à la pluralité de canaux (120), chacun via un chemin de connexion de vanne séparé (132), chacun des canaux formant le passage de fluide et étant pourvu de la première chambre de drainage et de la deuxième chambre de drainage.

13. Dispositif microfluidique selon la revendication 11, dans lequel au moins une portion du substrat (110) est transparente de manière à permettre aux ondes électromagnétiques de se propager à travers le substrat.

14. Dispositif microfluidique selon la revendication 11, comprenant en outre une unité d'actionnement (105) qui fait tourner le substrat, dans lequel le fluide est pompé par une force centrifuge générée quand l'unité d'actionnement fait tourner le substrat.
